# EUROPÄISCHE PATENTSCHRIFT

(11) **EP 4 092 431 B1**
(45) Veröffentlichungstag und Bekanntmachung des Hinweises auf die Patenterteilung: **08.01.2025**
(21) Anmeldenummer: 21175096.3
(22) Anmeldetag: 20.05.2021
(51) Int. Cl.: G01R 31/34, G01R 31/52

(54) **STROMRICHTERSCHALTKREIS UND STROMRICHTER**
POWER CONVERTER CIRCUIT AND POWER CONVERTER
CIRCUIT DE CONVERTISSEUR ET CONVERTISSEUR

(43) Veröffentlichungstag der Anmeldung: 23.11.2022
(73) Patentinhaber: Airbus (S.A.S.), 31700 Blagnac (FR)
(72) Erfinder: Kapaun, Florian, 82024 Taufkirchen (DE); Steiner, Gerhard, 82024 Taufkirchen (DE)
(74) Vertreter: OTN Airbus SAS

(56) Entgegenhaltungen:
- EP-A1- 3 165 491
- EP-A1- 3 631 927
- CN-C- 1 332 211
- DE-T5- 112014 002 853
- US-A1- 2001 048 310

## Beschreibung

Die Erfindung betrifft einen Stromrichterschaltkreis, einen Wechselrichter und weitere Vorrichtungen und Verfahren.

US 8 618 753 B2 offenbart einen Wechselrichter bei dem in jedem Phasenzweig ein Messshunt angeordnet ist.

JP 6 398 704 B2 und US 8 947 838 B2 offenbaren jeweils einen Wechselrichter bei dem ein Y-Kondensator parallel zu einem Zwischenkreiskondensator geschaltet ist.

EP 3 631 927 A1 offenbart eine Fernspeiseeinheit zur Bereitstellung von Gleichstrom für einen Fernspeiseempfänger in einem Gleichstromsystem. Eine Fehlerstromschutzschaltung umfasst einen ersten Schalter, der eine positive Spannungsschiene öffnet, und einen zweiten Schalter, der eine negative Spannungsschiene öffnet. Ein erster Stromsensor misst einen ersten Reststrom zwischen dem ersten Schalter und dem Fernstromempfänger, während der erste Schalter geschlossen und der zweite Schalter geöffnet ist. Ein zweiter Stromsensor misst einen zweiten Reststrom zwischen dem zweiten Schalter und dem entfernten Stromempfänger, während der zweite Schalter geschlossen und der erste Schalter geöffnet ist. Ein Controller erkennt ein Fehlerstromereignis, wenn der erste Fehlerstrom oder der zweite Fehlerstrom über einer Fehlerstromschwelle liegen.

DE 11 2014 002 853 T5 offenbart einen Isolationsdetektor, um mit einem einfachen Aufbau einen Isolationswiderstand einer Last oder einer Vorrichtung gegenüber einem Gehäuse oder Masse präzise zu erfassen oder zu messen.

EP 3 165 491 A1 offenbart ein Aufzugssystem sowie ein Verfahren zur Überwachung der elektrischen Sicherheit in einem Aufzugssystem. Eine Überwachungsschaltung ist konfiguriert, einen Erdschluss des Hauptstromkreises festzustellen.

CN 1 332 211 C offenbart ein Verfahren zur Erkennung von Erdungsfehlern in einem Gleichstromversorgungssystem und eine Erfassungsschaltung zur Verfügung.

US 2001 / 0 048 310 A1 offenbart einen Schaltkreis, der die Verschlechterung der Motorisolierung ermittelt, indem ein Gleichtaktleckstrom des Erdungskabels erfasst wird. Ein kleiner Stromwandler erfasst den Gleichtaktleckstrom, der im Erdungskabel der Motorsteuerungsschaltung fließt. Aus dem gemessenen Strom wird über mehrere Zwischenstationen ein impulsbreitenmoduliertes Signal mit einem Tastverhältnis erzeugt, das in Abhängigkeit von der Größe des Gleichtaktleckstroms variiert. Dieses Ausgangssignal wird direkt in einen Mikrocontroller oder einen digitalen Signalprozessor eingegeben, um das Ausmaß der Verschlechterung der Motorisolierung zu berechnen und zu bestimmen.

Es ist die Aufgabe der Erfindung, Maßnahmen vorzuschlagen, welche die Messbarkeit von kleinen Fehlerströmen in von Stromrichtern versorgten Stromkreisen zu verbessern.

Die Aufgabe wird durch den Gegenstand der unabhängigen Ansprüche gelöst. Bevorzugte Weiterbildungen sind Gegenstand der abhängigen Ansprüche.

Die Erfindung schafft einen Stromrichterschaltkreis für einen Wechselrichter, wobei der Stromrichterschaltkreis einen nachfolgend beschriebenen Strommessschaltkreis und wenigstens eine Schalteinrichtung aufweist, wobei die Schalteinrichtung zwischen die Versorgungsschienen geschaltet ist und einen elektrischen Ausgang hat.

Der Strommessschaltkreis umfasst eine positive Versorgungsschiene, eine negative Versorgungsschiene, eine Bezugspotentialschiene und eine Strommesseinrichtung, wobei die Strommesseinrichtung an jede Versorgungsschiene und an die Bezugspotentialschiene angeschlossen ist und die ausgebildet ist, einen elektrischen Fehlerstrom jeweils zwischen einer der Versorgungsschienen und der Bezugspotentialschiene zu messen.

Es ist bevorzugt, dass die Strommesseinrichtung wenigstens eine Strommessanordnung enthält, die entweder an die positive oder an die negative Versorgungsschiene sowie an die Bezugspotentialschiene angeschlossen ist, wobei die Strommessanordnung einen Stromsensor und einen in Serie dazu geschalteten Messkondensator enthält.

Es ist bevorzugt, dass der Stromsensor an eine der Versorgungsschienen sowie an den Messkondensator angeschlossen ist, wobei der Messkondensator an den Stromsensor und an die Bezugspotentialschiene angeschlossen ist.

Es ist bevorzugt, dass die Strommesseinrichtung eine erste Strommessanordnung und eine zweite Strommessanordnung enthält, wobei die erste Strommessanordnung an die positive Versorgungsschiene und die zweite Strommessanordnung an die negative Versorgungsschiene oder umgekehrt angeschlossen sind, wobei jede Strommessanordnung an die Bezugspotentialschiene angeschlossen ist und einen Stromsensor und einen dazu in Serie geschalteten Messkondensator enthält.

Es ist bevorzugt, dass der Messkondensator als Y-Kondensator konfiguriert ist.

Es ist bevorzugt, dass die Strommesseinrichtung einen Komparator enthält, der ausgebildet und angeschlossen ist, einen Überstrom durch die Strommessanordnung zu erkennen.

Es ist bevorzugt, dass die Strommesseinrichtung einen Komparator für jeden Stromsensor enthält, wobei jeweils ein Komparator an jeden Stromsensor angeschlossen ist.

Es ist bevorzugt, dass die Strommesseinrichtung einen Stromkreis zur Messung des Stromwertes, vorzugsweise einen A/D-Wandler enthält, der angeschlossen ist, um einen durch die Strommessanordnung fließenden analogen Fehlerstrom in ein digitales Fehlerstromsignal umzuwandeln, das indikativ für das Ausmaß des Fehlerstroms ist.

Vorzugsweise umfasst der Strommessschaltkreis einen Zwischenkreiskondensator der an zwischen die positive und die negative Versorgungsschiene geschaltet ist.

Es ist bevorzugt, dass der Zwischenkreiskondensator effektiv in Serie mit der Strommesseinrichtung oder jeder Strommessanordnung geschaltet ist.

Es ist bevorzugt, dass der Zwischenkreiskondensator näher an der Schalteinrichtung angeordnet ist als jede Strommessanordnung.

Die Erfindung schafft einen Wechselrichter umfassend einen bevorzugten Strom richterschaltkreis.

Die Erfindung schafft ein Strommessverfahren zum Feststellen eines aufgrund eines Isolationsfehlers in einem an einen Stromrichter angeschlossenen Stromkreis erzeugten Fehlerstromes, indem ein durch einen zwischen einer Versorgungsschiene des Stromrichters und eine Bezugspotentialschiene des Stromrichters geschalteten Kondensator fließender Strom bei einem Schaltvorgang des Stromrichters gemessen wird, wobei ein Isolationsfehler angenommen wird, wenn bei dem Schaltvorgang ein Stromfluss durch den Messkondensator gemessen wird, der einen vorgegebenen Schwellwert überschreitet.

Der Stromrichter als Wechselrichter konfiguriert ist, wobei der durch den Messkondensator fließende Strom während der positiven Halbwelle und/oder während der negativen Halbwelle gemessen wird, wobei ein Isolationsfehler angenommen wird, wenn bei einem der Schaltvorgänge ein Stromfluss durch den Messkondensator gemessen wird, der einen vorgegebenen Schwellwert überschreitet.

Die Erfindung wurde im technischen Bereich der leistungselektronischen Systeme gemacht. Deren Produktsicherheit und Fähigkeit zur Fehlererkennung spielt eine zentrale Rolle. Insbesondere Anwendungen bei der Elektrifizierung des Antriebsstrangs in Flugzeugen erfordern eine zuverlässige Fehlererkennung.

Ein Fehlermechanismus ist der sogenannte AC-Fehler, bei dem z.B. eine Phase eines mehrphasigen Umrichters oder Motors einen Isolationsfehler erleidet, der zu einer Fehlfunktion des Antriebsstrangs oder des gesamten Systems führen kann. Diese Systeme werden daher soweit wie möglich ausfallsicher entworfen.

Gemäß den hier vorgestellten Ideen wird ein neues Verfahren zur AC-Fehlererkennung vorgeschlagen, das einfacher zu implementieren und das zuverlässiger ist.

Die derzeit bekannten Methoden basieren im Wesentlichen auf der Strommessung an jeder Phase des Umrichters/Motors und der Bildung der Summe aller drei Phasen. Das Ergebnis dieser Summierung sollte einen Wert nahe Null ergeben, wenn es sich um ein symmetrisches AC-System handelt.

Eine Schwierigkeit ist es, dass die Lastströme meist um Größenordnungen höher liegen können als die Fehlerströme, die aufgrund von Asymmetrien durch Isolationsfehler entstehen können. Es ist daher bislang aufwändig, kleine Abweichungen zu erkennen, die ein Hinweis auf ein beginnendes Isolationsproblem sein können.

Um eine Verschlechterung der Isolation zu überwachen, werden üblicherweise gesonderte Isolationsüberwachungssysteme eingesetzt. Da diese möglichst nicht auf Netzrauschen reagieren sollen, haben diese Systeme meist eine lange Zeitkonstante. Die Reaktionsgeschwindigkeit ist daher auch im Falle höherer Fehlerströme vergleichsweise gering.

Eine andere Einschränkung ist, dass die genannten Isolationsüberwachungssysteme bislang nur bei symmetrischen Systemen angewandt werden können.

Mit den hierin vorgestellten Ideen ist eine schnellere und zuverlässigere AC-Fehlererkennung möglich. Zusätzlich ist die Implementierung einfacher gestaltet. Die Vorschläge können in nahezu jedem AC-System zur Erkennung von Isolationsfehlern in den Phasenzweigen eingesetzt werden. Die Erkennungsschaltung ist zusätzlich einfacher als bei herkömmlichen Verfahren.

Bei den gängigen Messmethoden (z.B. symmetrisches 3-Phasen-System) werden die Ströme in allen drei Phasen L1, L2, L3 separat gemessen (für die Rückführung). Es wird sodann die Summe IL = IL1 + IL2 + IL3 aller Ströme in den Phasenzweigen gebildet. Bei einem idealen symmetrischen System ist IL = 0, wenn kein Isolationsfehler auftritt. Im Fall eines AC-Fehlers ist IL ≠ 0.

Im Realfall liegt IL im Bereich von einigen Milliampere bis hinauf zu Nennstromwerten, sodass die Erkennung kleiner Werte schwierig sein kann, wenn die Messung auf die normalen Betriebspunkte ausgelegt ist. Ferner sind die meisten Systeme nicht 100% symmetrisch.

Stattdessen wird ein anderes Verfahren vorgeschlagen, das nicht die Summe der Phasenströme zur Erfassung verwendet. Vielmehr wird ein zusätzlicher Stromsensor - z.B. ein Shunt-Widerstand - in Reihe zu einem Y-Kondensator geschaltet. Im Idealbetrieb ist der Strom durch den Y-Kondensator gleich Null. Liegt jedoch ein AC-Fehler vor, wird das System unsymmetrisch und es fließt ein Strom durch den Y-Kondensator zurück in den Zwischenkreiskondensator.

Dieser Strom kann über einen Stromsensor (z. B. Shunt-Widerstand) erfasst und als Referenz für eine Fehlererkennung verwendet werden.

Der Strom liegt hierbei lediglich in einem kleinen Bereich und kann somit genauer als bisher erfasst werden. Die Strommessung liegt auf einem nicht-floatenden (DC-)Potential. Es kann eine einfache Komparatorschaltung verwendet werden.

Alternativ oder zusätzlich kann auch ein A/D-Wandler (ADC) zur Messung verwendet werden.

Ausführungsbeispiele werden im Folgenden anhand der beigefügten schematischen Zeichnungen näher erläutert. Darin zeigt:

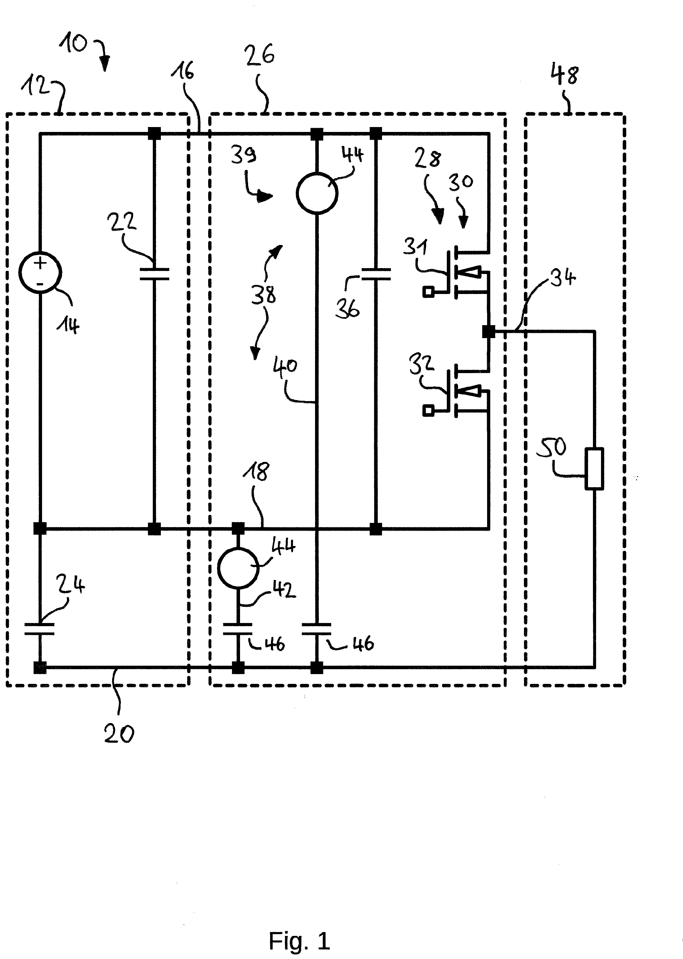

Fig. 1 ein Ausführungsbeispiel eines Stromkreises mit einem AC-Fehler.

Es wird nachfolgend auf Fig. 1 Bezug genommen, die ein Ausführungsbeispiel eines Stromkreises 10 zeigt. Der Stromkreis 10 umfasst einen Versorger 12, der eine Spannungsquelle 14 umfasst. Die Spannungsquelle 14 ist vorzugsweise eine Gleichspannungsquelle. Der Versorger 12 stellt eine positive Versorgungsschiene 16, eine negative Versorgungsschiene 18 und eine Bezugspotentialschiene 20 bereit. Die Bezugspotentialschiene 20 liegt auf einem Bezugspotential. Das Bezugspotential kann Erde sein. Das Bezugspotential liegt vorzugsweise in der Mitte zwischen den Potentialen der positiven und negativen Versorgungsschiene 16, 18.

Ferner kann der Versorger 12 einen Ausgangskondensator 22 aufweisen. Der Ausgangskondensator 22 ist zwischen die positive Versorgungsschiene 16 und die negative Versorgungsschiene 18 geschaltet.

Der Versorger 12 kann eine Kapazität 24 zwischen seinen Leitungen und einem auf Bezugspotential liegenden Gehäuse aufweisen. Die Kapazität 24 ist hier als Kondensator modelliert. Die Kapazität 24 kann - aber muss nicht - als Bauelement des Versorgers ausgestaltet sein. Der Versorger 12 ist hier lediglich zur besseren Erläuterung der Funktionsweise dargestellt und kann vielfältige Gestaltungen aufweisen, die als solches bekannt sind.

Der Stromkreis 10 umfasst einen Wechselrichter 26. Der Wechselrichter 26 enthält wenigstens einen Phasenzweig 28 mit einer Schalteinrichtung 30. Die Schalteinrichtung 30 umfasst zwei Leistungsschalter, die im Gegentakt betrieben werden können: einen ersten Leistungsschalter 31 und einen zweiten Leistungsschalter 32. Die Schalteinrichtung 30 umfasst ferner eine Ausgangsschiene 34. Die Ausgangsschiene 34 ist zwischen den beiden Leistungsschaltern 32 angeordnet.

Der Wechselrichter 26 enthält ferner einen Zwischenkreiskondensator 36, der zwischen die positiven Versorgungsschiene 16 und die negative Versorgungsschiene 18 geschaltet und vorzugsweise in der Nähe bzw. unmittelbar benachbart zu der Schalteinrichtung 30 angeordnet ist.

Der Wechselrichter 26 umfasst zudem einen Strommessschaltkreis 38. Der Strommessschaltkreis 38 ist an die beiden Versorgungsschienen 16, 18 sowie die Bezugspotentialschiene 20 angeschlossen. Der Strommessschaltkreis 38 umfasst eine Strommesseinrichtung 39, die ausgebildet ist, einen Strom zu messen.

Die Strommesseinrichtung 39 umfasst eine erste Strommessanordnung 40 und eine zweite Strommessanordnung 42. Die erste Strommessanordnung 40 ist an die positive Versorgungsschiene 16 und an die Bezugspotentialschiene 20 angeschlossen. Die zweite Strommesseinrichtung 42 ist an die negative Versorgungsschiene 18 und an die Bezugspotentialschiene 20 angeschlossen.

Jede Strommessanordnung 40, 42 enthält einen Stromsensor 44 und einen dazu in Serie geschalteten Messkondensator 46. Der Stromsensor 44 ist an die jeweilige Versorgungsschiene 16, 18 angeschlossen, während der Messkondensator 46 an die Bezugspotentialschiene 20 angeschlossen ist.

Die Messkondensatoren 46 jeder Strommessanordnung 40, 42 sind als Y-Kondensatoren zwischen den Versorgungsschienen 16, 18 und der Bezugspotentialschiene 20 geschaltet. Die Messkondensatoren 46 können je nach Fall auch Teil eines Entstörkondensatorsatzes sein.

Der Stromsensor 44 kann einen Shunt-Widerstand für die Strommessung enthalten. Der Shunt-Widerstand ist in Serie zu dem Messkondensator 46 geschaltet. Der Stromsensor 44 kann zusätzlich einen an den Shunt-Widerstand angeschlossenen Komparator für die Messung eines Überstroms in der jeweiligen Strommessanordnung 40, 42 enthalten. Optional kann der Stromsensor 44 einen A/D-Wandler für die exakte Quantifizierung des Überstroms enthalten.

Es wird nachfolgend davon ausgegangen, dass der Stromkreis 10 einen AC-Isolationsfehler 48 aufweist, der einen unerwünschten Stromfluss erlaubt und hier durch einen Widerstand 50 modelliert ist. Es können jedoch auch andere Arten von AC-Isolationsfehlern 48 detektiert werden. Der AC-Isolationsfehler 48 kann beispielsweise in einen Zuleitungssystem an eines oder mehrere Endgeräte oder in den Endgeräten selbst auftreten. Die Detektion eines Fehlerstroms erfolgt folgendermaßen:
Wenn der Leistungsschalter 31 eingeschaltet ist, wird der positive Pol der Spannungsquelle 14 durch den AC-Isolationsfehler 48 nach Bezugspotential, beispielsweise Masse, gedrückt. Wenn der Leistungsschalter 32 eingeschaltet ist, wird der negative Pol der Spannungsquelle 14 durch den AC-Isolationsfehler 50 nach Bezugspotential, hier Masse, gedrückt.

Diese Änderung der Versorgungsspannung in Bezug auf das Bezugspotential verursacht einen Ladungsträgerfluss durch jeden Messkondensator 46. Dieser Messstrom wird dann zur Ermittlung von des AC-Isolationsfehlers 48 verwendet.

Mit den hierin beschriebenen Maßnahmen können im Unterschied zu den bekannten Vorrichtungen und Verfahren zusätzlich AC-Isolationsfehler erkannt werden, die lediglich zu geringen Fehlstromwerten führen. Somit ist eine Frühzeiterkennung möglich. Zudem kann durch die direkte Messung des Stroms der Messkondensatoren der Messstrom vom eigentlichen Laststrom entkoppelt werden, sodass einfacher, schneller und genauer gemessen werden kann.

Um eine Frühzeiterkennung von AC-Isolationsfehlern (48) zu ermöglichen bzw. eine einfachere, schnellere und genauere Messung kleiner Ströme bei Wechselrichtern (26) zu erlauben, wird ein Strommessschaltkreis (38) für einen Stromrichter (26) vorgeschlagen. Der Strommessschaltkreis (38) hat eine positive Versorgungsschiene (16), eine negative Versorgungsschiene (18), eine Bezugspotentialschiene (20) und eine Strommesseinrichtung (39) die einen Y-Kondensator (46) und einen in Serie dazu geschalteten Stromsensor (44) enthält. Durch den wenigstens einen Y-Kondensator (46) kann der Laststrom vom Messstrom entkoppelt werden, sodass mit dem Stromsensor (44) bereits kleine Fehlströme auch bei hohen Lastströmen zuverlässig erfasst werden können.

### Bezugszeichenliste

- 10: Stromkreis
- 12: Versorger
- 14: Spannungsquelle
- 16: positive Versorgungsschiene
- 18: negative Versorgungsschiene
- 20: Bezugspotentialschiene
- 22: Ausgangskondensator
- 24: Kapazität
- 26: Wechselrichter
- 28: Phasenzweig
- 30: Schalteinrichtung
- 31: erster Leistungsschalter
- 32: zweiter Leistungsschalter
- 34: Ausgangsschiene
- 36: Zwischenkreiskondensator
- 38: Strommessschaltkreis
- 39: Strommesseinrichtung
- 40: erste Strommessanordnung
- 42: zweite Strommessanordnung
- 44: Stromsensor
- 46: Messkondensator
- 48: AC-Isolationsfehler
- 50: Widerstand

## Patentansprüche

1. Stromrichterschaltkreis für einen Wechselrichter (26), wobei der Stromrichterschaltkreis einen Strommessschaltkreis (38) und wenigstens eine Schalteinrichtung (30) aufweist, wobei der Strommessschaltkreis (38) eine positive Versorgungsschiene (16), eine negative Versorgungsschiene (18), eine Bezugspotentialschiene (20) und eine Strommesseinrichtung (39) umfasst, wobei die Schalteinrichtung (30) zwischen die Versorgungsschienen (16, 18) geschaltet ist und eine Ausgangsschiene (34) hat, wobei die Strommesseinrichtung (39) an jede Versorgungsschiene (16, 18) und an die Bezugspotentialschiene (20) angeschlossen ist, wobei die Strommesseinrichtung (39) ausgebildet ist, jeweils einen elektrischen Fehlerstrom zwischen einer der Versorgungsschienen (16, 18) und der Bezugspotentialschiene (20) zu messen.

2. Stromrichterschaltkreis nach Anspruch 1, **dadurch gekennzeichnet, dass** die Strommesseinrichtung (39) wenigstens eine Strommessanordnung (40, 42) enthält, die entweder an die positive oder an die negative Versorgungsschiene (16, 18) sowie an die Bezugspotentialschiene (20) angeschlossen ist, wobei die Strommessanordnung (40, 42) einen Stromsensor (44) und einen in Serie dazu geschalteten Messkondensator (46) enthält.

3. Stromrichterschaltkreis nach Anspruch 2, **dadurch gekennzeichnet, dass** der Stromsensor (44) an eine der Versorgungsschienen (16, 18) sowie an den Messkondensator (46) angeschlossen ist, wobei der Messkondensator (46) an den Stromsensor (44) und an die Bezugspotentialschiene (20) angeschlossen ist.

4. Stromrichterschaltkreis nach Anspruch 2 oder 3, **dadurch gekennzeichnet, dass** die Strommesseinrichtung (39) einen Komparator enthält, der ausgebildet und angeschlossen ist, einen Überstrom durch die Strommessanordnung (40, 42) zu erkennen.

5. Stromrichterschaltkreis nach einem der Ansprüche 2 bis 4, **dadurch gekennzeichnet, dass** die Strommesseinrichtung (39) einen Schaltkreis zur Messung des Stromwertes enthält, der angeschlossen ist, um einen durch die Strommessanordnung (40, 42) fließenden analogen Fehlerstrom in ein digitales Fehlerstromsignal umzuwandeln, das indikativ für das Ausmaß des Fehlerstroms ist.

6. Stromrichterschaltkreis nach einem der vorhergehenden Ansprüche, **gekennzeichnet durch** einen Zwischenkreiskondensator (36) der zwischen die positive und die negative Versorgungsschiene (16, 18) geschaltet ist.

7. Stromrichterschaltkreis nach Anspruch 6, **dadurch gekennzeichnet, dass** der Zwischenkreiskondensator (36) näher an der Schalteinrichtung (30) angeordnet ist als jede Strommessanordnung (40, 42).

8. Wechselrichter (26) umfassend einen Stromrichterschaltkreis nach einem der vorhergehenden Ansprüche.

9. Strommessverfahren zum Feststellen eines aufgrund eines AC-Isolationsfehlers (48) in einem an einen Stromrichter angeschlossenen Stromkreis (10) erzeugten Fehlerstromes, indem ein durch einen zwischen einer Versorgungsschiene (16, 18) des Stromrichters und eine Bezugspotentialschiene (20) des Stromrichters geschalteten Messkondensator (46) fließender Strom gemessen wird, wobei ein AC-Isolationsfehler (48) angenommen wird, wenn bei einem Schaltvorgang ein Stromfluss durch den Messkondensator (46) gemessen wird, der einen vorgegebenen Schwellwert überschreitet, wobei der Stromrichtert als Wechselrichter (26) konfiguriert ist, wobei der durch den Messkondensator (46) fließende Strom während der positiven Halbwelle und/oder während der negativen Halbwelle gemessen wird, wobei ein AC-Isolationsfehler (48) angenommen wird, wenn bei einem der Schaltvorgänge ein Stromfluss durch den Messkondensator (46) gemessen wird, der einen vorgegebenen Schwellwert überschreitet.

## Claims

1. A converter circuit for an inverter (26), the converter circuit comprising a current measuring circuit (38) and at least one switching device (30), the current measuring circuit (38) comprising a positive supply rail (16), a negative supply rail (18), a reference potential rail (20) and a current measuring device (39), the switching device (30) being connected between the supply rails (16, 18) and having an output rail (34), the current measuring device (39) being connected to each supply rail (16, 18) and to the reference potential rail (20), 18) and has an output rail (34), wherein the current measuring device (39) is connected to each supply rail (16, 18) and to the reference potential rail (20), wherein the current measuring device (39) is designed to measure an electrical fault current between one of the supply rails (16, 18) and the reference potential rail (20) in each case.

2. Converter circuit according to claim 1, **characterised in that** the current measuring device (39) contains at least one current measuring arrangement (40, 42) which is connected either to the positive or to the negative supply rail (16, 18) and to the reference potential rail (20), the current measuring arrangement (40, 42) containing a current sensor (44) and a measuring capacitor (46) connected in series therewith.

3. Converter circuit according to claim 2, **characterised in that** the current sensor (44) is connected to one of the supply rails (16, 18) and to the measuring capacitor (46), the measuring capacitor (46) being connected to the current sensor (44) and to the reference potential rail (20).

4. Converter circuit according to claim 2 or 3, **characterised in that** the current measuring device (39) contains a comparator which is designed and connected to detect an overcurrent through the current measuring arrangement (40, 42).

5. Converter circuit according to one of claims 2 to 4, **characterised in that** the current measuring device (39) includes a circuit for measuring the current value which is connected to convert an analogue fault current flowing through the current measuring arrangement (40, 42) into a digital fault current signal which is indicative of the magnitude of the fault current.

6. Converter circuit according to one of the preceding claims, **characterised by** an intermediate circuit capacitor (36) which is connected between the positive and the negative supply rail (16, 18).

7. Converter circuit according to claim 6, **characterised in that** the DC link capacitor (36) is arranged closer to the switching device (30) than any current measuring arrangement (40, 42).

8. inverter (26) comprising a converter circuit according to one of the preceding claims

9. A current measuring method for detecting a fault current generated due to an AC insulation fault (48) in a circuit (10) connected to a power converter by measuring a current flowing through a measuring capacitor (46) connected between a supply rail (16, 18) of the power converter and a reference potential rail (20) of the power converter (26), wherein an AC insulation fault (48) is assumed when a current flow through the measuring capacitor (46) is measured during a switching operation, which exceeds a predetermined threshold value, wherein the power converter is configured as an inverter (26), wherein the current flowing through the measuring capacitor (46) is measured during the positive half-wave and/or during the negative half-wave, wherein an AC isolation error (48) is assumed if a current flow through the measuring capacitor (46) which exceeds a predetermined threshold value is measured during one of the switching operations.

## Revendications

1. Circuit convertisseur pour un onduleur (26), le circuit convertisseur comprenant un circuit de mesure de courant (38) et au moins un dispositif de commutation (30), le circuit de mesure de courant (38) comprenant un rail d'alimentation positif (16), un rail d'alimentation négatif (18), un rail de potentiel de référence (20) et un dispositif de mesure de courant (39), le dispositif de commutation (30) étant connecté entre les rails d'alimentation (16, 18) et ayant une barre de sortie (34), le dispositif de mesure de courant (39) étant connecté à chaque barre d'alimentation (16, 18) et à la barre de potentiel de référence (20), le dispositif de mesure de courant (39) étant conçu pour mesurer respectivement un courant électrique de défaut entre l'une des barres d'alimentation (16, 18) et la barre de potentiel de référence (20).

2. Circuit convertisseur selon la revendication 1, **caractérisé en ce que** le dispositif de mesure de courant (39) comprend au moins un dispositif de mesure de courant (40, 42) qui est raccordé soit à la barre d'alimentation positive soit à la barre d'alimentation négative (16, 18) ainsi qu'à la barre de potentiel de référence (20), le dispositif de mesure de courant (40, 42) comprenant un capteur de courant (44) et un condensateur de mesure (46) monté en série avec celui-ci.

3. Circuit convertisseur selon la revendication 2, **caractérisé en ce que** le capteur de courant (44) est connecté à l'une des barres d'alimentation (16, 18) ainsi qu'au condensateur de mesure (46), le condensateur de mesure (46) étant connecté au capteur de courant (44) et à la barre de potentiel de référence (20).

4. Circuit convertisseur selon la revendication 2 ou 3, **caractérisé en ce que** le dispositif de mesure de courant (39) comprend un comparateur adapté et connecté pour détecter une surintensité à travers le dispositif de mesure de courant (40, 42).

5. Circuit convertisseur selon l'une des revendications 2 à 4, **caractérisé en ce que** le dispositif de mesure de courant (39) comprend un circuit de mesure de la valeur du courant connecté pour convertir un courant de défaut analogique circulant à travers le dispositif de mesure de courant (40, 42) en un signal de courant de défaut numérique indicatif de l'ampleur du courant de défaut.

6. Circuit convertisseur selon l'une des revendications précédentes, **caractérisé par** un condensateur de circuit intermédiaire (36) connecté entre les rails d'alimentation positif et négatif (16, 18).

7. Circuit convertisseur selon la revendication 6, **caractérisé en ce que** le condensateur de circuit intermédiaire (36) est disposé plus près du dispositif de commutation (30) que tout dispositif de mesure de courant (40, 42).

8. Onduleur (26) comprenant un circuit convertisseur selon l'une des revendications précédentes.

9. Procédé de mesure de courant pour détecter un courant de défaut généré en raison d'un défaut d'isolation AC (48) dans un circuit électrique (10) connecté à un convertisseur, en mesurant un courant circulant à travers un condensateur de mesure (46) connecté entre un rail d'alimentation (16, 18) du convertisseur et un rail de potentiel de référence (20) du convertisseur (26), dans lequel un défaut d'isolation AC (48) est supposé lorsqu'un courant circulant à travers le condensateur de mesure (46) est mesuré lors d'une opération de commutation, qui dépasse une valeur de seuil prédéterminée, le convertisseur de puissance étant configuré comme un onduleur (26), le courant circulant à travers le condensateur de mesure (46) étant mesuré pendant la demi-onde positive et/ou pendant la demi-onde négative, une erreur d'isolation AC (48) étant supposée si, lors d'une des opérations de commutation, un flux de courant circulant à travers le condensateur de mesure (46) et dépassant une valeur de seuil prédéterminée est mesuré.
